(19) Europäisches Patentamt
European Patent Office
Office européen des brevets

(11) **EP 3 667 892 A1**

(12) **EUROPEAN PATENT APPLICATION**
published in accordance with Art. 153(4) EPC

(43) Date of publication:
**17.06.2020 Bulletin 2020/25**

(51) Int Cl.:
**H02M 7/48** *(2007.01)*       **H02M 1/08** *(2006.01)*
**H05K 7/14** *(2006.01)*       **H05K 7/20** *(2006.01)*

(21) Application number: **18844422.8**

(22) Date of filing: **28.03.2018**

(86) International application number:
**PCT/JP2018/012824**

(87) International publication number:
**WO 2019/030968 (14.02.2019 Gazette 2019/07)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **09.08.2017 JP 2017154833**

(71) Applicant: **Hitachi, Ltd.**
**Tokyo 100-8280 (JP)**

(72) Inventors:
• **YAMAMOTO, Taku**
 **Tokyo 100-8280 (JP)**
• **FUKUI, Kotaro**
 **Tokyo 100-8280 (JP)**
• **HORIUCHI, Keisuke**
 **Tokyo 100-8280 (JP)**
• **INARIDA, Satoru**
 **Tokyo 100-8280 (JP)**

(74) Representative: **Mewburn Ellis LLP**
**Aurora Building**
**Counterslip**
**Bristol BS1 6BX (GB)**

(54) **POWER CONVERSION DEVICE AND COOLING METHOD THEREFOR**

(57)     In the present invention, P-pole and N-pole thin-plate-shaped busbars, formed to stand in a direction perpendicular to an attachment surface of 2in1 power semiconductor module, are adjacently to the power semiconductor module so as to face each other. The thin-plate-shaped busbars are connected terminals that are provided on a side of a filter capacitor at an offset to the power semiconductor module.

FIG. 1

## Description

Technical Field

The present invention relates to an electric-power conversion device on which a power semiconductor module is loaded and a cooling method therefor.

Background Art

An electric-power conversion device for railroad vehicle which is installed on the railroad vehicle is the one which subjects electric power which is input from a railroad overhead wire to electric-power conversion by a switching operation of a main circuit which is composed of a plurality of power semiconductor modules and controls an electric motor for railroad vehicle. The main circuit which is a main constitutional device of this electric-power conversion device is configured by the power semiconductor module which is a switching elements, a gate drive device which is a drive circuit thereof, a filter capacitor for stabilization of direct current electric power which is input from the overhead wire and so forth.

Here, miniaturization of the electric-power conversion device has been requested conventionally, and miniaturization of components themselves such as the power semiconductor module, the gate drive device, the filter capacitor and so forth is effective for realization of miniaturization thereof. Further miniaturization can be realized by efficiently arranging the components of the electric-power conversion device, in addition to this.

On the other hand, there is the possibility in the gate drive device that an electronic component that it mounts thereon may induce problems of malfunction and life reduction due to thermal effect. Here, since the power semiconductor module, an electric wire cable and so forth generate heat themselves and therefore there is the possibility that the vicinity thereof may reach a high temperature, it is requested to arrange the gate drive device by avoiding the thermal effect from surrounding heat generation components.

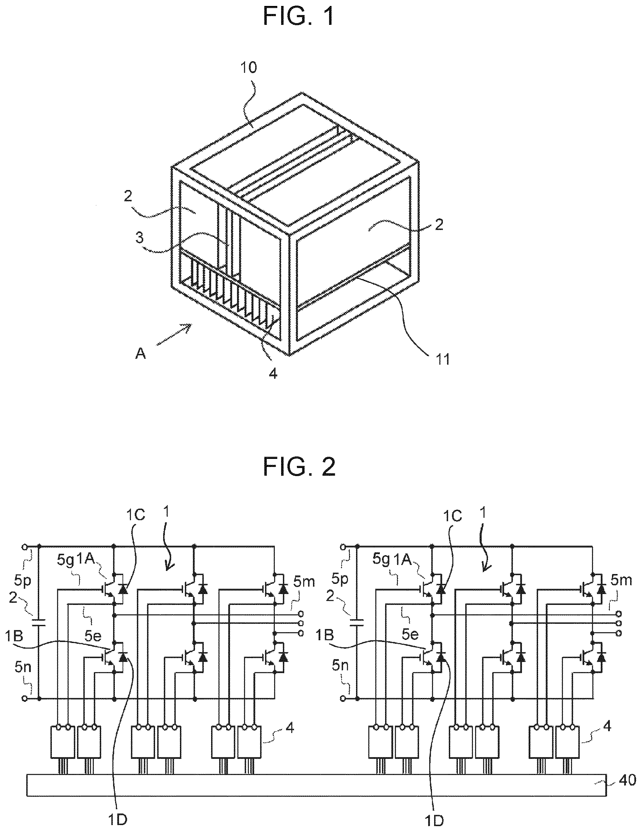

An electric-power conversion device that miniaturization and arrangement of the gate drive device are taken into consideration is described in Patent Literature 1. In Patent Literature 1, it is described that "a gate control circuit 7 is arranged on a lower-face part of an electric-power conversion unit 6, in a lower-face-part space of a filter capacitor 2, and on the front-face side (the opposite side of a cooling fin) in Fig. 1".

Citation List

Patent Literature

[Patent Literature 1] Japanese Patent Application Laid-Open No. 2010-284049

Summary of Invention

Technical Problem

In general, the electric-power conversion device is configured by a casing, the power semiconductor module, the filter capacitor, a cooling block, and the gate drive device. Here, in Patent Literature 1, the gate drive device is arranged on the gravity-direction lower side of the filter capacitor, taking that the gate drive device is used under a condition that the temperature of surrounding air is low into consideration as a conventional mounting system of the gate drive device.

However, in the conventional system, the gate drive devices are arranged even with the ground surface and laterally side by side. For realization of a small-sized electric-power conversion device in this equipment arrangement, it depends on the breath of the gate drive device and therefore a small-sized gate drive device was necessary.

In addition, in the gate drive devices which are arranged even with the ground surface and laterally side by side, air which was warmed by the gate drive devices flows along a crosswise direction of the gate drive devices and therefore the central gate drive device is exposed to a condition that a temperature environment is severe. Accordingly, it was concerned that electronic components which are mounted on the gate drive devices and soldered parts incidental thereto would be adversely affected by heat.

A subject of the present invention is to promote improvement of a heat radiation performance of the gate drive device and miniaturization of the electric-power conversion device.

Solution to Problem

In order to solve the above-mentioned subject, representative one of electric-power conversion devices of the present invention is equipped with a power semiconductor module which has a plurality of switching elements which configure an electric-power conversion circuit, a filter capacitor which smooths a direct current voltage which is applied to the electric-power conversion circuit, and one, two or more gate drive device(s) which send(s) a control signal(s) for controlling switching operations of the plurality of switching elements to the plurality of switching elements, in which the one, two or more gate drive device(s) is/are arranged perpendicularly to the ground surface.

Advantageous Effects of Invention

According to the present invention, improvement of the heat radiation performance of the gate drive device and miniaturization of the electric-power conversion device can be promoted.

Brief Description of Drawings

Fig. 1 is a perspective diagram of an electric-power conversion device of a first embodiment.
Fig. 2 is an electric circuit diagram of the electric-power conversion device of the first embodiment.
Fig. 3 is a front view of the electric-power conversion device of the first embodiment.
Fig. 4 is a side view of the electric-power conversion device of the first embodiment.
Fig. 5 is a bottom view of the electric-power conversion device of the first embodiment.
Fig. 6 is a perspective diagram of an electric-power conversion device of a second embodiment.

Description of Embodiments

In the following, embodiments of the present invention will be described by using the drawings.

[First Embodiment]

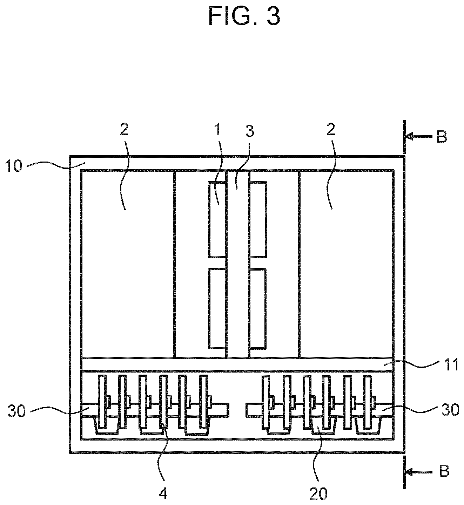

A first embodiment of the present invention will be described by using Fig. 1 to Fig. 5.
First, a basic structure example of an electric-power conversion device in the present embodiment is illustrated in Fig. 1. Fig. 1 is a perspective diagram of the electric-power conversion device of the first embodiment. In Fig. 1, the present electric-power conversion device is configured by a casing 10, a power semiconductor module 1 (not illustrated), a filter capacitor 2, a cooling block 3, and a gate drive device 4, and is loaded on, for example, a vehicle body of a railroad vehicle. The casing 10 is configured into the box shape by using a frame-shaped frame body and is arranged on or under the vehicle body. In the casing 10, a plurality of the filter capacitors 2, and the cooling block 3 are housed in its upper region, and a plurality of the gate drive devices 4 are housed in a lower region. On this occasion, the filter capacitors 2 are arranged with the cooling block 3 being interposed therebetween. The bottom sides of the cooling block 3 and each filter capacitor 2 are supported on a support frame 11 which is fixed to the casing 10.
On this occasion, the respective gate drive devices 4 are arranged on the lower sides (the lower sides in a gravity acting direction) of the filter capacitors 2 and perpendicularly to the ground surface in the lower region in the casing 10. In addition, the respective gate drive devices 4 are arranged adjacently to each other/one another and are side by side in a lateral direction (the direction which intersects a rail) along the ground surface at regular intervals. In this case, a longitudinal direction of each gate drive devices 4 is arranged along the rail. Further, a connector (not illustrated) which is an optical fiber connection terminal that a command signal from a control logic unit 40 (see Fig. 2) is input is arranged on each gate drive device 4 so as to expose to a front face of the casing 10. For this reason, attachment and detachment of the connector becomes easy.
An electric-power conversion circuit of the electric-power conversion device in the present embodiment is illustrated in Fig. 2. Fig. 2 is an electric circuit diagram of the electric-power conversion device of the first embodiment. In Fig. 2, the present electric-power conversion device is equipped with two sets of the electric-power conversion circuits. Each of the present electric-power conversion circuits outputs an alternate current voltage to M-pole wiring 5m with a direct current voltage which is applied between P-pole wiring 5p and N-pole wiring 5n being received as an input. The filter capacitor 2 which is adapted to smooth the direct current voltage is connected between the P-pole wiring 5p and the N-pole wiring 5n. Conversion from the direct current voltage to the alternate current voltage is realized by switching operations of a plurality of switching element which belong to each power semiconductor module 1. Specifically, each power semiconductor module is equipped with one set of the electric-power conversion circuits, and this electric-power conversion circuit is configured by, for example, three sets (three pairs) of IGBTs (Insulated Gate Bipolar Transistor) 1A, 1B which are connected in series with one another, and freewheel diodes 1C, 1D which are connected in parallel between a collector and an emitter of each of the IGBTs 1A and 1B as the plurality of switching elements which configure a three-phase inverter. A gate and the emitter of each of the IGBTs 1A, 1B are connected to each gate drive device 4 via gate wiring 5g and emitter wiring 5e respectively, and each of the IGBTs 1A, 1B receives a control signal from the gate drive device 4 and performs the switching operation. This switching operation is done in linkage with a gate voltage that each gate drive device 4 outputs. The gate voltage is generated by each gate drive device 4 on the basis of a command signal which is transmitted from the control logic unit 40 which is connected to each gate drive device 4. Incidentally, the present electric-power conversion device is not limited to the one which configures the two sets of the electric-power conversion circuits by one present electric-power conversion device, and may be the one which configures one set, three or more sets of the electric-power conversion circuits.
An equipment arrangement of the present embodiment in an arrow view A in Fig. 1 is illustrated in Fig. 3. Fig. 3 is a front view of the electric-power conversion device of the first embodiment. In Fig. 3, the cooling block 3 is arranged on a central part of an upper region in the casing 10, and the plurality of power semiconductor modules 1 are arranged on both side-faces of the cooling block 3. In addition, the filter capacitors 2 are arranged on the both sides of the cooling block 3 with space parts being maintained therebetween. A cooling water circulation passage (not illustrated) through which cooling water circulates is formed in the cooling block 3 in such manner that the plurality of switching elements (not illustrated) which belongs to each power semiconductor module 1 are cooled with the cooling water which circulates through the cooling block 3.

The plurality of gate drive devices 4 having control circuits which generate control signals which are adapted to apply control signals to the respective switching elements (IGBTs), and a plurality of transformers 20 which are connected to the control circuits so as to, for example, boost the control signals are arranged in the region which is the lower region in the casing 10 and is under the support frame 11. Each gate drive device 4 is arranged on the lower side (the lower side in the gravity acting direction) of the filter capacitor 2 and perpendicularly to the ground surface in the lower region in the casing 10. On this occasion, each gate drive device 4 is arranged on the front-face side (the frontal side) which is more forward than each transformer 20 and is fixed to a gate drive fixing plate which is fixed to the casing via an L-shaped tray and a spacer (none of them are illustrated). Each transformer 20 is arranged on the back-face side which is more backward than each gate drive device 4 and is fixed to a transformer fixing plate 30 which is fixed to the casing 10. It becomes easy for air which is warmed by each gate drive device 4 to escape toward the upper side via the space part between the filter capacitor 2 and the cooling block 3 by arranging each gate drive device 4 perpendicularly to the ground surface. That is, each gate drive device 4 can be cooled by introducing the air from the gravity-direction lower side (the bottom side of the casing 10) of each gate drive device 4 onto the gravity-direction upper side of each gate drive device 4. Thereby, it becomes easy to supply cold air to each gate drive device 4, and improvement of the heat radiation performance can be more promoted than in a case where each gate drive device 4 is arranged in a horizontal direction.

Here, heat transfer coefficients in a case where each gate drive device 4 is arranged horizontally and in a case where each gate drive device 4 is arranged vertically can be obtained from the following calculation formulae. In addition, the following calculation formulae are the ones which are generally defined and are not limited to the present invention.

Incidentally, respective symbols in the following calculation formulae are set as Nu: Nusselt number, Gr: Grashof number, Pr: Prandtl number, L: representative dimension, g: gravitational acceleration, $\beta$: coefficient of cubical expansion, $\gamma$: coefficient of kinematic viscosity, $\lambda$: thermal conductivity, $\Delta\theta$: difference in temperature, h: heat transfer coefficient, A: heat transfer surface area of the gate drive device 4.

In a case where the gate drive device 4 is arranged horizontally, the heat transfer coefficient h can be obtained by the following calculation formulae (Numerical Formula 1 to Numerical formula 3).

[Numerical Formula 1]

$$Nu = 0.27(Gr \cdot \text{Pr})^{\frac{1}{4}}$$

[Numerical Formula 2]

$$Gr \cdot \text{Pr} = \frac{L^3 \cdot g \cdot \beta \cdot \Delta\theta}{v^2} \cdot \text{Pr}$$

[Numerical Formula 3]

$$h = \frac{Nu \cdot \lambda}{L}$$

In addition, in a case where the gate drive device 4 is arranged vertically, the heat transfer coefficient h can be obtained by the above-mentioned calculation formula (Numerical Formula 3) from the following calculation formula (Numerical Formula 4) and the above-mentioned calculation formula (Numerical Formula 2).

[Numerical Formula 4]

$$Nu = 0.59(Gr \cdot \text{Pr})^{\frac{1}{4}}$$

Here, the conditions are made the same as each other in a case where the gate drive device 4 is made horizontal or vertical, they are set as Pr = 0.72, L = 0.1(m), g = 9.8(m/s$^2$), $\beta$ = 3.1x10$^{-3}$(1/K), $\gamma$ = 1.79x10$^{-5}$(m$^2$/s), $\lambda$ = 0.0276(W/mK), $\Delta\theta$ = 60(K) respectively.

When the heat transfer coefficients in the case where each gate drive device 4 is arranged horizontally and the case where each gate drive device 4 is arranged vertically are obtained from the above-mentioned calculation formulae, in the case where each gate drive device 4 is arranged horizontally, h = 3.35(W/m$^2$K), and in the case where each gate drive device 4 is arranged vertically, h = 7.33(W/m$^2$K). It can be seen that in the case where each gate drive device 4 is arranged vertically, the heat transfer coefficient becomes large in this way, and it is easy to dissipate heat of each gate drive device 4 to the atmosphere. Accordingly, in the case where each gate drive device 4 is arranged vertically, improvement of the heat radiation performance can be promoted in comparison with the case where each gate drive device 4 is arranged horizontally.

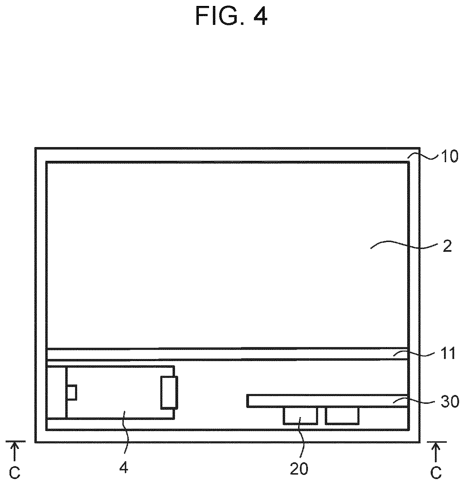

An equipment arrangement in an arrow view B in Fig. 3 is illustrated in Fig. 4. Fig. 4 is a side view (the side view along the B-B line in Fig. 3) of the electric-power conversion device of the first embodiment. In Fig. 4, the plurality of gate drive devices 4 are arranged in one line in the region which is the lower region in the casing 10 and is under the support frame 11. The plurality of transformers 20 are arranged in two lines in the region which is the lower region in the casing 10 and is under the support frame 11. On this occasion, a space part is formed between each gate drive device 4 and each transformer 20. In the present electric-power conversion device, each gate drive device 4 of a light electricity system and each transformer 20 of a heavy electricity system are separately arranged. That is, each gate drive device main body (the gate drive device 4 which builds the control circuit therein), and each transformer 20 are arranged separately from each other. Here, in a case where each gate drive device 4 is integrated with each transformer 20, the transformer 20 is high and therefore a spacing between the adjacent gate drive devices 4 cannot be narrowed. In addition, since the transformer 20 itself generates heat, other pieces of equipment in the gate drive device 4 and the adjacent gate drive devices 4 are influenced by heat generation. On the other hand, when each gate drive device 4 and each transformer 20 are arranged separately as in the present electric-power conversion device, each gate drive device 4 is not influenced by heat generation of each transformer 20 and can be arranged by narrowing the spacing between the adjacent gate drive devices 4. Accordingly, a rail-direction length of the casing 10 ban be made short. Incidentally, the connector (not illustrated) which is adapted to perform command signal transmission and reception with the control logic unit 40 is arranged on the side-face side (the front-face side of the casing 10) of each gate drive device 4 as the connection terminal or a terminal part so as to be exposed to the outside of the casing 10.

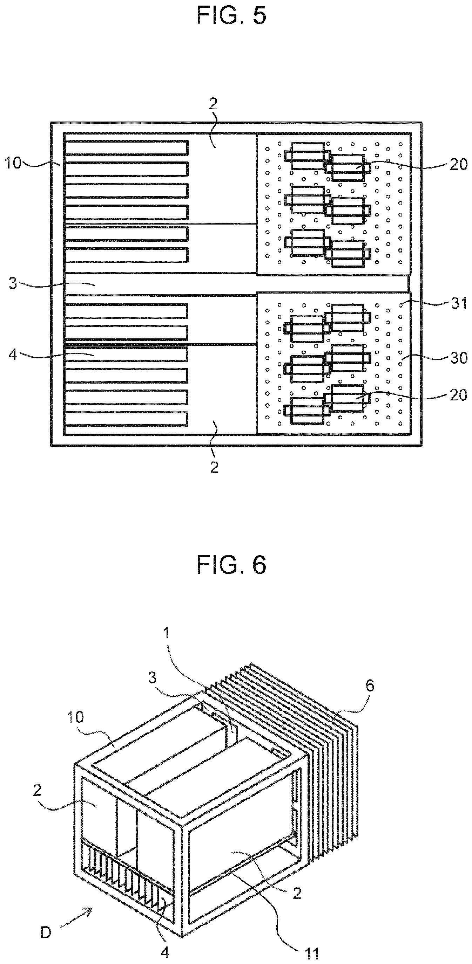

An arrangement of the gate drive devices 4 and the transformers 20 in an arrow view C in Fig. 4 is illustrated in Fig. 5. Fig. 5 is a bottom view (the bottom view along the C-C line in Fig. 4) of the electric-power conversion device of the first embodiment. In Fig. 5, the present electric-power conversion device is equipped with the transformer fixing plate 30 which has a ventilation hole for improvement of a cooling performance of the transformer 20 and transformer fixing hole 31. The plurality of gate drive devices 4 are arranged in one line, and the plurality of transformers 20 are arranged in two lines. On this occasion, the plurality of transformers 20 are arranged on the two transformer fixing plates 30 six by six. The ventilation holes for improvement of the cooling performance of the transformer 20 and transformer fixing holes 31 are plurally formed in each transformer fixing plate 30 over the entire surface thereof. The respective ventilation holes and transformer fixing holes 31 are formed in each transformer fixing plate 30 over the entire surface thereof in order to make it possible to freely change the arrangement of each transformer 20.

Here, since each transformer 20 is connected with each gate drive device 4 by wiring, necessity to change an attachment position of any of the transformers 20 occurs depending on a length of the wiring and a route of the wiring. On the other hand, since the present electric-power conversion device has the plurality of ventilation holes and transformer positioning holes 31, each transformer 20 can be arranged at an optional position on each transformer fixing plate 30 without being influenced by the length and the route of the wiring, and improvement of workability in attachment of the transformers 20 can be promoted.

In addition, the present electric-power conversion device can dissipate the heat which is generated in each transformer 20 toward the upper side of each transformer 20 through the ventilation hole and transformer fixing hole 31, and thereby can promote improvement of the cooling performance of each transformer 20.

In addition, in the arrangement of the respective transformers 20, since in a case where the respective transformers 20 are attached on the same straight line, a width of the number of the transformers 20 becomes necessary, there is the possibility that the size of the electric-power conversion device may become large. On this occasion, the plurality of transformers 20 are dispersedly arranged in the hound's-tooth check form. Thereby, an attachment width of the plurality of transformers 20 can be suppressed, and the electric-power conversion device can be more miniaturized.

According to the present embodiment, improvement of the heat radiation performance of the gate drive devices 4 and miniaturization of the electric-power conversion device can be promoted. In addition, according to the present embodiment, since the respective gate drive devices 4 are arranged on the lower side of the filter capacitor 2 and perpendicularly to the ground surface, and, further, the respective gate drive devices 4 are arranged adjacently to each other/one another and side by side in the lateral direction (the direction which intersects the rail) along the ground surface, a reduction in pressure loss, improvement of a travelling wind taking-in amount and improvement of the heat transfer coefficient can be promoted, and, as a result, improvement of the cooling performance and the life of each gate drive device 4 can be promoted. In addition, the switching element can be cooled with the cooling water which circulates through the cooling block 3.

[Second Embodiment]

In the present embodiment, the semiconductor module 1 and the filter capacitor 2 are arranged on one side of the cooling block 3, and a cooling fin 6 is arranged on the other side unlike the first embodiment. In the following, description will be made with a focus on points which are different from those in the first embodiment.

A structure example of the electric-power conversion device in the present embodiment is illustrated in Fig. 6. Fig. 6 is a perspective diagram of the electric-power conversion device of the second embodiment. In Fig. 6, in the present electric-power conversion device, the cooling block 3 is arranged on the back-face side in the casing 10, and a space part which is larger than that in the first embodiment is formed between the filter capacitor 2 and the filter capacitor 2. The plurality of power semiconductor modules 1 are fixed to the front-face side (one side) of the cooling block 3, and the cooling fin 6 which is exposed from the casing 10 to the outside of the vehicle body is fixed to the back-face side of the cooling block 3. The cooling fin 6 functions as a radiator which radiates heat of the power semiconductor module 1 (heat of the switching elements and so forth) to the atmosphere. On this occasion, the power semiconductor module 1 can be cooled by natural air-cooling via the cooling fin 6 without circulating the cooling water in the cooling block 3.

Each gate drive device 4 is arranged on the gravity-direction lower side of the filter capacitor 2 and perpendicularly to the ground surface similarly to that in the first embodiment.

In the present embodiment, although the respective filter capacitors 2 are dividedly arranged on the left and the right in a case of viewing from the front-face side (an arrow view D in Fig. 6), the filter capacitors 2 may be formed as an integrated type one.

According to the present embodiment, the same effects as those of the first embodiment can be exhibited, and the power semiconductor module 1 can be cooled by natural air-cooling via the cooling fin 6. In addition, according to the present embodiment, since the cooling block 3 is arranged on the back-face side of the casing 10, and the space part which is larger than that in the first embodiment is formed between the filter capacitors 2, the heat radiation performance of each gate drive device 4 can be more heightened than that in the first embodiment.

Incidentally, the present invention is not limited to the above-described embodiments and various modified examples are included. For example, even in a case of one gate drive device 4, improvement of the heat radiation performance of the gate drive device 4 can be promoted, and the electric-power conversion device can be miniaturized by vertically arranging the gate drive device 4. The above-described embodiments are the ones which are described in detail for the purpose of comprehensively describing the present invention and it is not necessarily limited to the one which is equipped with all the configurations which have been described. In addition, it is possible to replace part of a configuration of one embodiment with a configuration of another embodiment and it is also possible to add a configuration of another embodiment to a configuration of one embodiment. In addition, it is possible to add, delete and replace another configuration to, from and with part of one configuration of each embodiment.

Reference Signs List

1 power semiconductor module, 2 filter capacitor, 3 cooling block, 4 gate drive device, 5p P-pole wiring, 5n N-pole wiring, 5m M-pole wiring, 5g gate wiring, 5e emitter wiring, 6 cooling fin, 10 casing, 11 support frame, 20 transformer, 30 transformer fixing plate, 31 ventilation hole and transformer fixing hole, 40 control logic unit

Claims

1. An electric-power conversion device comprising:

   a power semiconductor module which has a plurality of switching elements which configure an electric-power conversion circuit;
   a filter capacitor which smooths a direct current voltage which is applied to the electric-power conversion circuit; and
   one, two or more gate drive device(s) which send(s) a control signal(s) for controlling switching operations of the plurality of switching elements to the plurality of switching elements, wherein
   the one, two or more gate drive device(s) is/are arranged perpendicularly to the ground surface.

2. The electric-power conversion device according to claim 1, wherein
   the two or more gate drive devices are arranged adjacently to each other/one another and side by side along the ground surface.

3. The electric-power conversion device according to claim 1 or 2, wherein
   the one, two or more gate drive device(s) has/have a control circuit(s) which generate(s) the control signal(s) for controlling the switching operations of the plurality of switching elements, and one, two or more transformer(s) adapted to boost the control signal(s), and the control circuit(s) and the one, two or more transformer(s) are arranged separately from each other/one another.

4. The electric-power conversion device according to claim 3, wherein
   the two or more transformers are arranged in the hound's-tooth check form.

5. The electric-power conversion device according to claim 3 or 4, wherein
   the one, two or more transformer(s) is/are fixed to a transformer fixing plate in which a plurality of holes which are used as ventilation holes and used for fixing the transformers simultaneously are formed dispersedly.

6. The electric-power conversion device according to any one of climes 1 to 5, wherein
   the power semiconductor module, the filter capacitor and the one, two or more gate drive device(s) are housed in a common casing, and the one, two or more gate drive device(s) is/are housed in a gravity-direction lower-side region in the casing.

7. The electric-power conversion device according to claim 6, wherein
a connection terminal(s) for connection with a control logic unit which performs command signal transmission and reception with the control circuit is/are arranged on the one, two or more gate drive device(s) at a position(s) where it/they is/are exposed to the outside of the casing.

8. The electric-power conversion device according to any one of claims 1 to 7, wherein
the power semiconductor module is fixed to a cooling block which has a cooling water circulation passage through which cooling water circulates, and the plurality of switching elements which belong to the power semiconductor module are cooled with the cooling water which circulates through the cooling water circulation passage.

9. The electric-power conversion device according to any one of claims 1 to 7, wherein
the power semiconductor module is fixed to a cooling block which has a cooling fin, and the plurality of switching elements which belong to the power semiconductor module are cooled by heat radiation of the cooling fin.

10. A cooling method for an electric-power conversion device which includes
a power semiconductor module which has a plurality of switching elements which configure an electric-power conversion circuit,
a filter capacitor which smooths a direct current voltage which is applied to the electric-power conversion circuit, and
one, two or more gate drive device(s) which send(s) a control signal(s) for controlling switching operations of the plurality of switching elements to the plurality of switching elements, comprising:
arranging the one, two or more gate drive device(s) perpendicularly to the ground surface; and introducing air on the gravity-direction lower side(s) of the one, two or more gate drive device(s) onto the gravity-direction upper side(s) of the one, two or more gate drive device(s) so as to cool the one, two or more gate drive device(s) therewith.

11. The cooling method for the electric-power conversion device according to claim 10, comprising:
arranging the two or more gate drive devices adjacently to each other/one another and side by side along the ground surface.

12. The cooling method for the electric-power conversion device according to claim 10 or 11, comprising:
fixing the power semiconductor module to a cooling block which has a cooling water circulation passage through which cooling water circulates; and cooling the plurality of switching elements which belong to the power semiconductor module with the cooling water which circulates through the cooling water circulation passage.

13. The cooling method for the electric-power conversion device according to claim 10 or 11, comprising:
fixing the power semiconductor module to a cooling block which has a cooling fin; and cooling the plurality of switching elements which belong to the power semiconductor module by heat radiation of the cooling fin.

# FIG. 1

# FIG. 2

# FIG. 3

FIG. 4

# FIG. 5

# FIG. 6

**EP 3 667 892 A1**

| | | INTERNATIONAL SEARCH REPORT | International application No. |
|---|---|---|---|
| | | | PCT/JP2018/012824 |

A. CLASSIFICATION OF SUBJECT MATTER
Int. Cl. H02M7/48(2007.01)i, H02M1/08(2006.01)i, H05K7/14(2006.01)i,
H05K7/20(2006.01)i

According to International Patent Classification (IPC) or to both national classification and IPC

B. FIELDS SEARCHED

Minimum documentation searched (classification system followed by classification symbols)
Int. Cl. H02M7/48, H02M1/08, H05K7/14, H05K7/20

Documentation searched other than minimum documentation to the extent that such documents are included in the fields searched
Published examined utility model applications of Japan       1922-1996
Published unexamined utility model applications of Japan     1971-2018
Registered utility model specifications of Japan             1996-2018
Published registered utility model applications of Japan     1994-2018

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2012/108048 A1 (MITSUBISHI ELECTRIC CORP.) 16 | 1-2, 6, 9-11, |
|   | August 2012, paragraphs [0011], [0012], [0015]- | 13 |
| Y | [0017], [0024], [0030], [0034], fig. 1-4 & US | 8, 12 |
| A | 2013/0322141 A1, paragraphs [0021], [0022], | 3-5, 7 |
|   | [0025]-[0027], [0034], [0040], [0044], fig. 1-4 & |   |
|   | EP 2675053 A1 & CN 103354971 A |   |
|   | | |
| Y | JP 2006-166509 A (MITSUBISHI ELECTRIC CORP.) 22 | 8, 12 |
| A | June 2006, paragraphs [0010]-[0013] (Family: none) | 1-7, 9-11, 13 |

☒ Further documents are listed in the continuation of Box C.   ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 24.04.2018 | 15.05.2018 |

| Name and mailing address of the ISA/ | Authorized officer |
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

12

**INTERNATIONAL SEARCH REPORT**

| International application No. |
|---|
| PCT/JP2018/012824 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2016-213945 A (HITACHI, LTD.) 15 December 2016, paragraphs [0009], [0014], [0022], [0027], fig. 1, 2, 4 & GB 2541966 A, page 3, lines 10-22, page 4, line 22 to page 5, line 10, page 10, line 20 to page 11, line 12, fig. 1, 2, 4 & DE 102016207639 A1 & CN 106130363 A | 1-13 |
| A | JP 2013-179104 A (HITACHI AUTOMOTIVE SYSTEMS, LTD.) 09 September 2013, paragraphs [0059], [0060], fig. 18 & WO 2013/128995 A1 | 1-13 |

Form PCT/ISA/210 (continuation of second sheet) (January 2015)

**EP 3 667 892 A1**

**Patent documents cited in the description**

- JP 2010284049 A